Europäisches Patentamt

European Patent Office

Office européen des brevets

(19)

(11) EP 0 707 348 A1

(12) **DEMANDE DE BREVET EUROPEEN**

(43) Date de publication:
**17.04.1996 Bulletin 1996/16**

(51) Int Cl.$^6$: **H01L 39/14**

(21) Numéro de dépôt: **95402256.2**

(22) Date de dépôt: **09.10.1995**

(84) Etats contractants désignés:
**AT BE CH DE DK ES GB IT LI NL SE**

(30) Priorité: **12.10.1994 FR 9412163**

(71) Demandeur: **GEC ALSTHOM
ELECTROMECANIQUE SA
F-75016 Paris (FR)**

(72) Inventeurs:
• **Verhaege, Thierry
F-91160 Saulx Les Chartreux (FR)**

• **Estop, Pascal
F-94400 Vitry sur Seine (FR)**
• **Tavergnier, Jean-Pierre
F-91310 Linas (FR)**
• **Bonnet, Patrick
F-90300 Cravanche (FR)**
• **Lacaze, Alain
F-90850 Essert (FR)**
• **Laumond, Yves
F-90400 Andelnans (FR)**

(74) Mandataire: **Fournier, Michel
SOSPI
14-16, rue de la Baume
F-75008 Paris (FR)**

(54) **Conducteur supraconducteur pour applications à haute tension**

(57) L'invention a pour objet un conducteur supraconducteur pour applications à hautes et très hautes tensions comprenant une pluralité de brins supraconducteurs multifilamentaires torsadés avec au moins un brin en matériau non supraconducteur, le brin en matériau non supraconducteur étant en contact électrique avec les brins supraconducteurs, selon l'invention le brin en matériau non supraconducteur a une résistivité de l'ordre de la résistivité desdits brins multifilamentaires à l'état non supraconducteur, et le brin en matériau non supraconducteur a une section telle que le courant de transition passant dans la section totale du conducteur supraconducteur soit au plus égal à 500 A par millimètre carrée de ladite section totale.

FIG.3

EP 0 707 348 A1

## Description

La présente invention concerne un conducteur supraconducteur utilisable pour des applications à hautes et très hautes tensions, dans lesquelles le conducteur est parcouru par de très fortes intensités.

Il peut s'agir par exemple de limiteurs de courant supraconducteurs destinés à protéger des lignes à haute tension et dans lesquels la tension peut atteindre plusieurs centaines de kilovolts et l'intensité plusieurs milliers d'ampères.

Lorsqu'un conducteur supraconducteur parcouru par un courant subit une transition le faisant passer à l'état normal, sa résistance augmente et par suite de l'effet Joule, ce conducteur s'échauffe. La température maximale atteinte par le conducteur est fonction de l'intégrale de la densité de puissance dans le conducteur.

Les conducteurs supraconducteurs utilisés dans les applications à basse tension développent, lors d'une transition les faisant passer de l'état supraconducteur à l'état normal, une résistance qui fait décroître très rapidement le courant et la densité de puissance dissipée. Le conducteur est ainsi auto-protégé contre une température excessive.

Le domaine d'application de cette possibilité d'auto-protection a été étendu aux conducteurs à moyenne tension (quelques kV) par l'utilisation de conducteurs ayant une vitesse élevée de propagation de la transition, donc une augmentation rapide de la résistance. (De une à quelques dizaines de km/s).

EP-A-0505975 concerne un conducteur supraconducteur protégé des transitions partielles. Ce conducteur supraconducteur comprend une pluralité de brins supraconducteurs multifilamentaires torsadés avec au moins un brin en matériau non supraconducteur. Le brin en matériau non supraconducteur est au contact mécanique sans cohésion avec les brins supraconducteurs.

Le principe mis en oeuvre pour protégé le conducteur supraconducteur est basé sur l'augmentation de la vitesse de propagation de la transition, donc une augmentation rapide de la résistance qui fait décroître rapidement le courant et la densité de puissance dissipée.

EP-A-0440127 concerne un conducteur supraconducteur protégé des transitions partielles.

Ce conducteur supraconducteur comprend une pluralité de brins supraconducteurs multifilamentaires torsadés avec au moins un brin en matériau non supraconducteur. Le brin en matériau non supraconducteur est isolé des brins supraconducteurs, mais est ponctuellement connecté électriquement aux brins supraconducteurs. Le brin en matériau non supraconducteur est composé d'une matrice ayant une résistivité supérieure à 10-8 Ω.m à 4,2 K dans laquelle est noyé un filament de métal non supraconducteur ayant une résistivité inférieure à 10-9 Ω.m à 4,2 K, mais fortement dépendante de la température. Ce métal non supraconducteur peut être aussi présent dans les brins supraconducteur.

Dans ce cas aussi le principe mis en oeuvre pour protégé le conducteur supraconducteur est basé sur l'augmentation de la vitesse de propagation de la transition, donc une augmentation rapide de la résistance qui fait décroître rapidement le courant et la densité de puissance dissipée.

Pour les applications à hautes et très hautes tensions la résistance ne se développe pas suffisamment et suffisamment vite pour faire décroître la densité de puissance dans le conducteur. Il en résulte un échauffement excessif conduisant à la destruction du conducteur.

Un but de la présente invention est de définir un conducteur supraconducteur pour applications à hautes et très hautes tensions capable de résister à toute transition.

L'invention a pour objet un conducteur supraconducteur pour applications à hautes et très hautes tensions comprenant une pluralité de brins supraconducteurs multifilamentaires torsadés avec au moins un brin en matériau non supraconducteur, le brin en matériau non supraconducteur étant en contact électrique avec les brins supraconducteurs. Selon l'invention le brin en matériau non supraconducteur a une résistivité de l'ordre de la résistivité desdits brins multifilamentaires à l'état non supraconducteur, et le brin en matériau non supraconducteur a une section telle que le courant de transition passant dans la section totale du conducteur supraconducteur soit au plus égal à 500 A par millimètre carrée de ladite section totale.

Dans un mode particulier de réalisation, le conducteur supraconducteur comprend un brin central unique en matériau non supraconducteur autour duquel sont torsadés les brins multifilamentaires.

De préférence, les brins multifilamentaires sont au moins au nombre de 10.

Dans un mode particulier de réalisation, le conducteur supraconducteur est compacté par tréfilage après torsadage.

Préférentiellement, le matériau du brin non supraconducteur est un alliage de cuivre et de nickel.

Dans ce cas, le nickel est dans une proportion de l'ordre de 30% en poids dans l'alliage.

Le principe mis en oeuvre pour protégé le conducteur supraconducteur selon l'invention est basé sur l'évacuation par un ou des brins non supraconducteurs de la chaleur résultant de la transition des brins supraconducteurs pour limiter la température du conducteur jusqu'au déclenchement du disjoncteur, alors que le principe de l'art antérieur repose sur l'utilisation de cette chaleur pour augmenter la résistivité des brins et donc diminuer le courant de transition pour une autorégulation du conducteur.

L'invention sera bien comprise à la lecture de la description ci-après de divers modes de réalisation de l'invention, en référence au dessin annexé dans lequel:

- la figure 1 est une vue en coupe d'un conducteur supraconducteur selon l'art antérieur,
- la figure 2 est une vue en coupe d'un conducteur selon un premier mode de réalisation de l'invention,

- la figure 3 est une vue en coupe d'un conducteur selon un second mode de réalisation de l'invention,
- la figure 4 est une vue en coupe d'un conducteur selon un troisième mode de réalisation de l'invention.
- les figures 5A et 5B sont des diagrammes des variations du courant et de la densité de puissance dissipée après une transition, dans diverse hypothèses,
- la figure 6 est une courbe montrant les caractéristiques d'un conducteur selon l'invention, en fonction du nombre de brins supraconducteurs multifilamentaires.

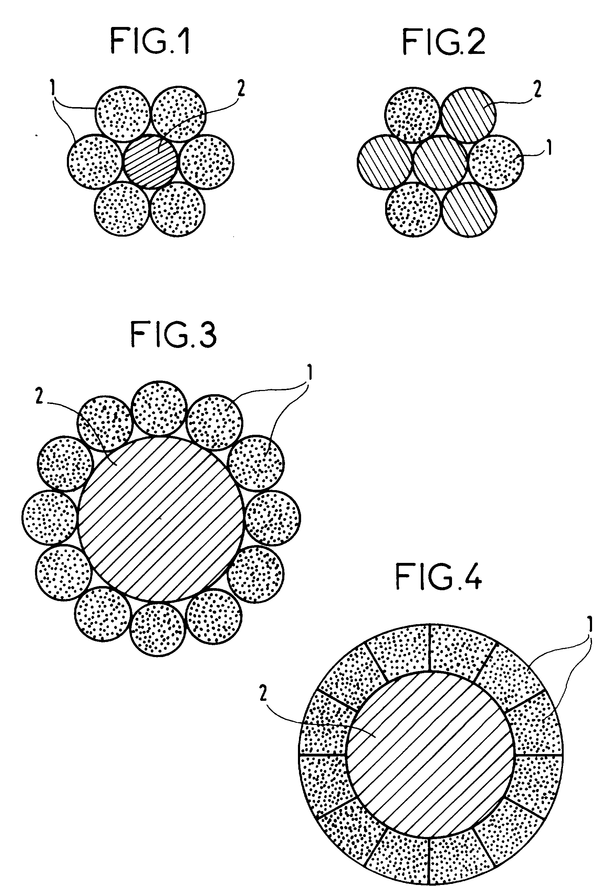

Les conducteurs classiquement utilisés en basse et moyenne tension sont souvent des conducteurs de type "6+1", comme celui représenté dans la figure 1, qui comprennent 6 brins supraconducteurs multifilamentaires, référencés 1 et représentés avec des points, toronnés ou torsadés avec un brin 2 en matériau non supraconducteur, tel que du cuivre ou un alliage de cuivre et de nickel, représenté avec des hachures. Ces mêmes références et conventions de représentation seront utilisées dans les autres figures. Les brins supraconducteurs multifilamentaires sont par exemple du type de celui décrit dans le brevet français n°69 10338 déposé le 3 avril 1969, et qui comportent, dans une matrice de cupro-nickel, plusieurs centaines de milliers de filaments de niobium-titane.

On a indiqué plus haut pourquoi un tel conducteur supraconducteur ne peut convenir pour les applications à hautes et très hautes tensions.

Le conducteur proposé par l'invention est caractérisé par la présence d'un brin en matériau non supraconducteur dont la résistivité est de l'ordre de celle des brins supraconducteurs à l'état transité, avec une section importante par rapport à la section totale des brins supraconducteurs, et en contact électrique avec lesdits brins.

La figure 2 montre en section un conducteur selon un premier mode de réalisation de l'invention, comprenant 3 brins supraconducteurs multifilamentaires 1 et quatre brins 2 en matériau non supraconducteur, qui est de préférence en alliage cupro-nickel avec une proportion de l'ordre de 30% en poids de nickel.

La figure 3 montre un second mode de réalisation comprenant douze brins supraconducteurs multifilamentaires 1 torsadés autour d'un gros brin 2 en matériau non supraconducteur, avantageusement l'alliage de cupro-nickel précité.

La figure 4 montre une variante de réalisation dans laquelle le conducteur de la figure 3 a été compacté par tréfilage.

Le rapport de la section de matériau non supra conducteur à la section de passage supraconductrice est calculé pour que le câble absorbe la puissance dissipée dans le conducteur lors d'une transition, pendant l'intervalle de temps $\Delta t$ précédant la coupure du courant effectuée par le disjoncteur en série avec le limiteur, et ce, sans atteindre une température finale excessive.

On observera que les résistivités des différents brins étant du même ordre, la dissipation de chaleur est à peu près homogène dans la section du conducteur, ce qui évite qu'un brin particulier atteigne une température excessive.

La densité d'énergie maximale dissipée dans le conducteur est:

$$Q(J/m^3) \ 1/2. \ \rho_{eq}.(I_q/S)^2. \ \Delta t$$

Dans cette relation:

$\rho_{eq}$ ($\Omega.m$) est la résistance équivalente du conducteur à l'état non supraconducteur,
$S(m^2)$ est la section du conducteur,
$I_q(A)$ est l'intensité du courant de transition.

Comme la production de chaleur est particulièrement intense, la densité d'énergie Q est principalement absorbée par l'inertie thermique du conducteur, de sorte que:

$$Q \ H(T_f) - H(T_i)$$

relation dans laquelle:

$H(J/m^3)$ est l'enthalpie du conducteur
$T_i$ et $T_f$ sont respectivement les températures initiale et finale du conducteur.

C'est la raison pour laquelle le conducteur de l'invention peut être dénommé "conducteur enthalpique".

Si on limite à $10^9$ J/m$^3$ la densité maximale d'énergie dans le conducteur, le calcul conduit à une densité maximale de courant de 500A/mm$^2$, de sorte que la section totale du conducteur doit être supérieure à Iq/ 5.10$^8$ m$^2$.

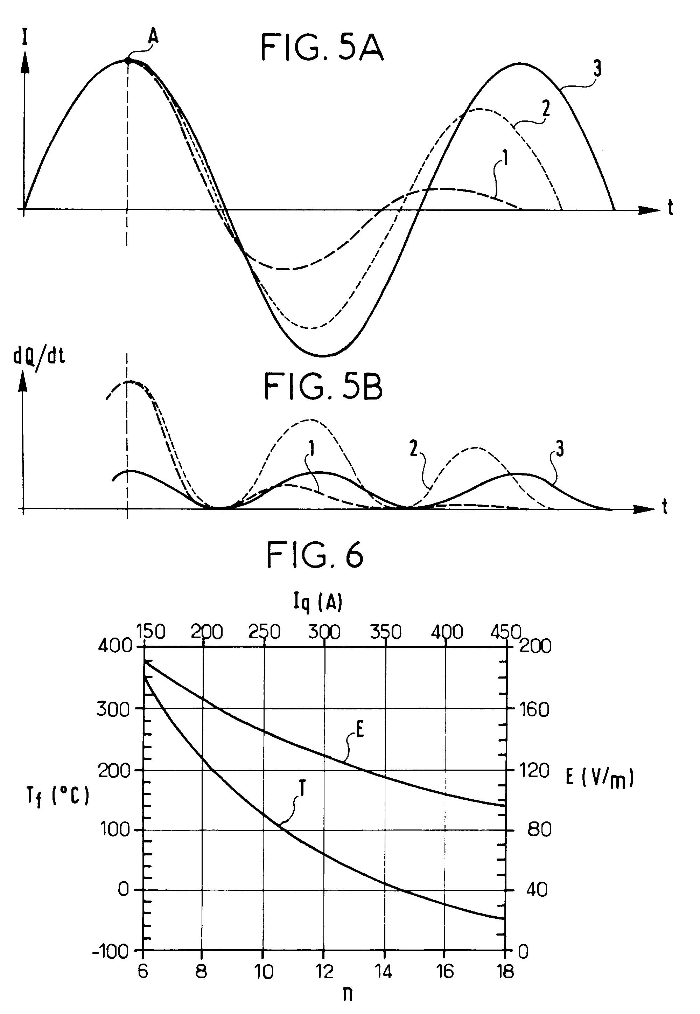

La figure 5A montre l'évolution en fonction du temps t, du courant I dans un conducteur supraconducteur après une transition supposée s'amorcer au point A. La figure 5B montre l'évolution correspondante de la densité de puissance dissipée dQ/dt.

Les courbes 1 correspondent à une application à basse tension avec un conducteur de l'art antérieur. La résistance du conducteur suffit à faire décroître le courant qui est coupé par le disjoncteur au premier passage par zéro du courant après l'ouverture du disjoncteur qui intervient 20ms après le début de la transition.

Les courbes 2 montrent les mêmes évolutions pour une application à haute tension avec un conducteur supraconducteur classique à grande vitesse de transition. Ces courbes mettent en évidence que la diminution de résistance ne permet de limiter le courant que dans une proportion réduite.

Les courbes 3 montrent les même évolutions avec le conducteur enthalpique de l'invention. On voit bien que le parti est pris de ne plus espérer de réduction rapide du courant, mais bien de dissiper l'énergie au sein même du conducteur.

La figure 6 indique les caractéristiques calculées du conducteur enthalpique réalisé selon le modèle de la figure 3, avec un nombre n de conducteurs multifilamentaires supraconducteurs variable de 6 à 18. La section relative du noyau central de cupro-nickel augmente lorsque le nombre de brins supraconducteur augmente. Les calculs effectués supposent que les conducteurs filamentaires multibrins ont un diamètre de 0,2mm, un courant de blocage $I_q$ de 25A et une résistivité à l'état normal de 40$\mu\Omega$.cm. Le champ électrique E est appliqué à l'état normal lorsque le pic de courant égale le courant de blocage; il détermine la longueur nécessaire pour le conducteur, pour une tension donnée. La température finale $T_f$ après 20ms de limitation est calculée à partir la densité d'énergie Q, dans l'hypothèse d'une évolution adiabatique. On constate à l'examen de la courbe que la température $T_f$ (en °C) est trop élevée pour les faibles valeurs de n; elle devient acceptable pour n par exemple supérieur à 10.

L'invention s'applique à la réalisation de limiteurs supraconducteurs à haute tension.

## Revendications

1. Conducteur supraconducteur pour applications à hautes et très hautes tensions comprenant une pluralité de brins supraconducteurs multifilamentaires torsadés avec au moins un brin en matériau non supraconducteur, le brin en matériau non supraconducteur étant en contact électrique avec les brins supraconducteurs caractérisé en ce que le brin en matériau non supraconducteur a une résistivité de l'ordre de la résistivité desdits brins multifilamentaires à l'état non supraconducteur, et en ce que le brin en matériau non supraconducteur a une section telle que le courant de transition passant dans la section totale du conducteur supraconducteur soit au plus égal à 500 A par millimètre carrée de ladite section totale.

2. Conducteur supraconducteur selon la revendication 1, caractérisé en ce qu'il comprend un brin central unique en matériau non supraconducteur autour duquel sont torsadés les brins multifilamentaires.

3. Conducteur supraconducteur selon l'une des revendications 1 à 3, caractérisé en ce que les brins multifilamentaires sont au moins au nombre de 10.

4. Conducteur selon l'une des revendications 1 à 4, caractérisé en ce qu'il est compacté par tréfilage après torsadage.

5. Conducteur supraconducteur selon l'une des revendications 1 à 4, caractérisé en ce que le matériau du brin non supraconducteur est un alliage de cuivre et de nickel.

6. Conducteur supraconducteur selon la revendication 5, caractérisé en ce que le nickel est dans une proportion de l'ordre de 30% en poids dans l'alliage.

FIG.1

FIG.2

FIG.3

FIG.4

# FIG. 5A

# FIG. 5B

# FIG. 6

Office européen
des brevets

**RAPPORT DE RECHERCHE EUROPEENNE**

Numero de la demande

EP 95 40 2256

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| X,D | EP-A-0 505 975 (ALSTHOM GEC) 30 Septembre 1992 <br> * le document en entier * <br> --- | 1-6 | H01L39/14 |
| A,D | EP-A-0 440 127 (ALSTHOM GEC) 7 Août 1991 <br> * abrégé; figure 1 * <br> --- | 1-6 | |
| A | EP-A-0 156 626 (AMERICAN MAGNETICS CORP) 2 Octobre 1985 <br> * abrégé; figure 3 * <br> ----- | 1-6 | |

**DOMAINES TECHNIQUES RECHERCHES (Int.Cl.6)**

H01L

Le présent rapport a été établi pour toutes les revendications

| Lieu de la recherche | Date d'achèvement de la recherche | Examinateur |
|---|---|---|
| LA HAYE | 23 Janvier 1996 | Pelsers, L |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons
........................................................................
& : membre de la même famille, document correspondant

EPO FORM 1503 03.82 (P04C02)